(19) Europäisches Patentamt
European Patent Office
Office européen des brevets

(11) **EP 2 399 680 A1**

(12) **EUROPEAN PATENT APPLICATION**

(43) Date of publication:
**28.12.2011 Bulletin 2011/52**

(51) Int Cl.:
*B08B 3/12* (2006.01)   *B08B 7/00* (2006.01)
*C30B 33/00* (2006.01)   *G02B 1/02* (2006.01)
*G02B 1/10* (2006.01)

(21) Application number: **11181764.9**

(22) Date of filing: **23.07.2008**

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **31.07.2007 US 962718 P**

(62) Document number(s) of the earlier application(s) in accordance with Art. 76 EPC:
**08794669.5 / 2 185 298**

(71) Applicant: **Corning Incorporated**
**Corning, New York 14831 (US)**

(72) Inventors:
• **Cangemi, Michael J**
  **Victor, NY New York 14564 (US)**
• **Feng, Jiangwei**
  **Painted Post, NY New York 14870 (US)**
• **Hayden, Cindy J**
  **Rochester, NY New York 14617 (US)**
• **Sabia, Robert**
  **Corning, NY New York 14830 (US)**
• **Schreiber, Horst**
  **Rochester, NY New York 14607 (US)**
• **Wang, Jue**
  **Fairport, NY New York 14450 (US)**

(74) Representative: **Oldroyd, Richard Duncan**
**Elkington and Fife LLP**
**Prospect House**
**8 Pembroke Road**
**Sevenoaks, Kent TN13 1XR (GB)**

Remarks:
This application was filed on 19-09-2011 as a divisional application to the application mentioned under INID code 62.

(54) **DUV optic**

(57) The invention is directed to a DUV optic, said optic comprising a shaped single crystal alkaline earth metal fluoride optical element having a lifetime of at least 1.2 billion pulses when exposed to 120 mJ/cm$^2$ radiation, wherein said alkaline earth metal is Mg, Ca, Ba and Sr, or mixtures thereof.

Figure 1

EP 2 399 680 A1

## Description

Cross-reference to Related Applications

This application claims the benefit of priority under 35 U.S.C. § 119(e) of U.S. Provisional Application Serial No. 60/962718 filed on July 31, 2007.

Field

This invention is directed to improved coated optical elements that can be used for the transmission of deep ultraviolet electromagnetic radiation, and in particular to improved coated alkaline earth metal fluoride optical elements that thereby have greater durability and improved transmissivity for use as DUV optics which can, for example, be used as laser optics, in optical inspection systems and also optical lithography; and additionally to a method for making such optical elements.

Background

The use of high power lasers, for example, those with pulse energy densities (fluence) above 10 mJ/cm$^2$, pulse repetition rates above 5kHz and with pulse lengths in the low nanometer range, can degrade the optics used in laser lithography systems. T.M. Stephen et al., in their article "Degradation of Vacuum Exposed SiO2 Laser Windows" SPIE Vol. 1848, pp. 106-110 (1992), report on the surface degradation of fused silica in Ar-ion laser. More recently, it has been noticed that there is optical window surface degradation in high peak and average power 193 nm excimer lasers using window materials made from substances other than silica. There is also evidence that such degradation will be more severe when existing optical materials are used in 157 nm laser systems. While some solutions, for example, such as using MgF$_2$ as the window or lens material for existing 193 nm laser systems have been proposed, it is believed that such materials will also experience surface degradation with time, leading to the requirement that the expensive windows be periodically replaced. It is further believed that the problem with window degradation will be exacerbated with the advent of laser systems operating at wavelengths below 193 nm. In addition, the use of MgF$_2$ as a window material, while it might be successful from a mechanical viewpoint, presents a problem of color center formation that is detrimental to transmission performance of the laser beam.

Excimer lasers are the illumination sources of choice for the microlithographic industry. While ionic materials as such as crystals MgF$_2$, BaF$_2$ and CaF$_2$ are the materials of choice for excimer optical components due to their ultraviolet transparencies and to their large band gap energies, the preferred material is CaF$_2$. However, crystals of CaF$_2$ and the optical elements made from CaF$_2$ are difficult to optically polish. Furthermore, polished but uncoated surfaces of CaF$_2$ are susceptible to degradation when exposed to powerful excimer lasers operating in the deep ultraviolet ("DUV") range of less than 250 nm, for example at 248 and 193 nm. For lasers operating at 193 nm, with repetition rates above 2 KHz, with pulse energy densities of 10-40 mJ/cm$^2$, the surfaces or the optical elements made from these ionic materials are known to fail after only a few million laser pulses. The cause of the damage is thought to be fluorine depletion in the top surface layers of the polished surface. See Wang et al., "Color center formation on CaF2 (111) surface investigated by using low-energy-plasma-ion surfacing", Optical Society of America 2004, [2004_OSA_OF&T] and Wang et al., "Surface assessment of CaF2 deep-ultraviolet and vacuum-ultraviolet optical components by the quasi-Brewster angle technique," Applied Optics, Vol. 45, No. 22 (August 2006), pages 5621 - 5628. US Patent 6,466,365 (the "365 patent) describes a method of protecting metal fluoride surfaces, such as CaF2, from degradation by use of a vacuum deposition, of a silicon oxyfluoride coating/material. While for the moment this is a reasonable solution, the microlithographic industry constantly demands more performance from excimer sources, and consequently from optical components used in connection with Excimer laser based systems. Therefore, in view of the expected increased industry demands for improved laser performance, it is desirable to find a solution to the optical element degradation problem that will either eliminate the problem or will greatly extend the durability, and consequently the length of time that existing and future optical components can be used.

Summary

In one aspect, the invention is directed to a method of cleaning the surface of optical elements prior to coating them, the optical elements being made from metal fluoride single crystals of formula MF$_2$, where M is calcium, barium, magnesium, or strontium, or mixtures of the foregoing, that are used as DUV optics, for example, in below 200 nm laser lithography and other system involving lasers. Such DUV optics include, prisms, windows, stepper lenses and any other optic used with below 200 nm lasers.

In another aspect the invention is directed to a method for cleaning surfaces of optical elements made from metal fluoride single crystals of formula $MF_2$, where M is calcium, barium, magnesium, or strontium, or mixtures of the foregoing, prior to coating the elements with films of protective materials. In one embodiment the invention is directed to a method for cleaning the surface of optical elements made from single crystal alkaline earth fluorides $MF_2$ prior to their being coated with selective materials to extend their laser damage threshold. The selected coating material can be any known in the art, for example, silica, fluorine doped silica, silicon nitride, fluorine doped aluminum oxide and, in the case of $CaF_2$, $BaF_2$ and $SrF_2$ the coating material can be $MgF_2$.

In another aspect the invention is directed to a method for cleaning surfaces of optical elements made from metal fluoride single crystals of formula $MF_2$, where M is calcium, barium, magnesium, or strontium, or mixtures of the foregoing, prior to coating the elements with films of protective materials, the method having at least the steps:

(1) Immersion of the optical element in a selected liquid and utilizing sonication at megasonic frequencies to remove particulates, polishing slurry residue and the damaged top layer of the optical element;
(2) A gas phase cleaning process whereby hydrocarbons are removed from the surface of the optical element using UV/ozone cleaning; and
(3) Exposure, in a gas phase process, of the optical element's surface to a low-energy plasma containing argon and oxygen, xenon and oxygen, or fluorine in a vacuum environment.

Brief Description of the Drawings

Figure 1 is the process diagram of the three step cleaning process of the invention illustrating the use of megasonic cleaning, UVO cleaning and *in situ* argon/oxygen, xenon/oxygen or fluorine plasma cleaning.
Figure 2 is a step height image of an etched $CaF_2$ surface using deionized water.
Figure 3 is a comparison of a $CaF_2$ surface cleaned by wiping versus a $CaF_2$ that is megasonically cleaned, the left and right figures showing magnesium and sodium, respectively, as a function of depth.
Figure 4 is the measured quasi-Brewster shift as a function of UVO cleaning time of a $CaF_2$ surface at 193 nm and 248 nm showing the effectiveness of decontamination at 193 nm.
Figure 5 is a logarithmic plot of samples prepared according to the invention that were tested under accelerated, high fluence conditions and their projected lifetime under lower fluence conditions.

Detailed Description

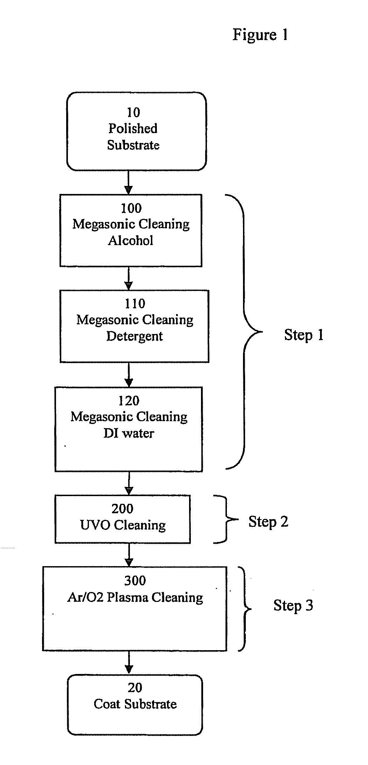

Herein $CaF_2$ single crystal surfaces are used to illustrate the advantages of cleaning using the method of the invention. However, it should be made clear that the method of the invention is applicable to other $MF_2$ surfaces, where M is Mg, Ca, Ba and Sr.
Ultrasonic cleaning methods have been widely used for cleaning optical components prior to deposition. However, when utilizing ultrasonic frequencies to clean the surfaces of many substrates such as alkaline earth metal fluorides care must be taken to minimize surface damage to the substrate. Using ultrasonic frequencies, cavitations on the order of 2 microns or greater can be produced (at 40 kHz the bubble size can be on the order of 8 - 10 microns) resulting in an aggressive process as the cavitation bubbles burst upon impact with the substrate surface. Due to the violent bubble collapse as it impacts an optical surface during ultrasonic cleaning, surface damage such as pitting and roughening of the surface is common. Megasonic cleaning methods produce smaller cavitation sizes (at 800 kHz this could be on the order of 800 nm) and is considered to be a gentler process than ultrasonic cleaning. Examples of the technical literature of megasonic cleaning are G. Gale et al., How to Accomplish Effective Megasonic Particle Removal, Semiconductor International, August 1996, pages 133-138, and Gale et al. Roles of Cavitation and Acoustic Streaming in Megasonic Cleaning, Particulate Science and Technology, Vol. 17 (1999), pages 229-238.
The method of the invention, which is schematically represented in Figure 1, has three major steps which are:

(1) Immersion of the optical element in a selected liquid and utilizing sonication at megasonic frequencies to remove particulates, polishing slurry residue and the damaged top layer of the optical element;
(2) A gas phase cleaning process whereby hydrocarbons are removed from the surface of the optical element using UV/ozone cleaning; and
(3) Exposure, in a gas phase process, of the optical element's surface to a low-energy plasma containing argon and oxygen in a vacuum environment.

Megasonic cleaning is carried out at frequencies of approximately 0.7 to 2 MHz. The megasonic cleaning is carried out for a time in the range of 2 minutes to 1 hour. When a plurality of cleaning tanks is used, the cleaning time in each tank can be in the range of 2 minutes to 1 hour. Thus, when three cleaning tanks are used as indicated below the total cleaning time can be in the range of 6 minutes to three hours. The sequence of sub-steps shown in Figure 1, which are described below in detail, are:

> Numeral 10: Receiving the substrate from final polishing.
> Numeral 100: Megasonic cleaning using HPLC Grade methanol or ethanol.
> Numeral 110: Megasonic cleaning using aqueous high pH detergent solution.
> Numeral 120: Megasonic cleaning using overflow deionized ("DI") water rinsing.
> Numeral 200: UVO cleaning.
> Numeral 300: Low energy $Ar/O_2$ $Xe/O_2$ or fluorine plasma cleaning. The procedure is done under vacuum in a coating chamber.
> Numeral 400: Coating the substrate.

The three part cleaning method of the invention uses a fluid based medium with sonication as a first step followed by two gas phase cleaning steps. The sonication process as used in the invention is done at megasonic frequencies which are in the approximate range of 0.7 - 2 MHz. The fluid mediums used in the megasonic cleaning tanks are hydrocarbon based and aqueous based. The hydrocarbon based solvents are used to remove residues and particulates from the surface without etching the optical surface. The aqueous based solvents are used to gently etch the surface of the substrate since the alkaline earth metal fluorides have a solubility in water ($MgF_2$ = 0.076 g/l, $CaF_2$ = 0.016 g/l, $BaF_2$ = 1.7 g/l and $SrF_2$ = 0.39 g/l).

A cleaning method using sonication at megasonic frequencies is highly desirable for polished optical surfaces such as $CaF_2$, $BaF_2$ and $MgF_2$ where the aim is to remove residues and particulates with a minimal increase in surface roughness. Cleaning using megasonic frequencies is favored over ultrasonic frequencies (ultrasonic frequencies are < 400 kHz) due to the fact that megasonic produce a controlled cavitation process with smaller cavitation bubble sizes. Bubbles generated during megasonic cleaning are in the submicron level size, have a more stable cavitation and release significantly less energy than that generated by ultrasonic frequency levels. The most significant benefit of megasonic cleaning is the formation of an acoustic boundary layer and acoustic micro-streaming induced forces. The thin acoustic boundary layer produced in megasonic cleaning combined with the high velocity acoustic streaming of the process not only enhances the total drag force exerted on particles and thus dislodges them more efficiently from the substrate, but the combination also results in higher mass-transport near the surface being cleaned. This higher mass-transport refreshes the cleaning chemistry of the process more efficiently

UV Ozone ("UVO") cleaning is an effective solution for decontamination of hydrocarbons from $CaF_2$ surface. Hydrocarbon contamination of optical components in the DUV (deep ultraviolet) region is a widely documented problem. Hydrocarbons are highly absorbing in the DUV region. Cleaning methods which incorporate UV radiation with ozone has been shown to be successful for dealing with hydrocarbons. Since $CaF_2$ is transparent to the UV light, the UVO cleaning also removes some subsurface contamination without introducing extra damage to the optical surface. Low-energy plasma cleaning containing an Ar and $O_2$ gas mixture within the vacuum chamber prior to film deposition further removes both molecular and particulate contamination from the optical surface. The *in situ* cleaning process avoids recontamination issues and improves film adhesion to the substrate surface.

Megasonic Cleaning

The megasonic cleaning step can be done in one or a plurality of sonication tanks. The use of a plurality of tank is preferred to avoid having to empty and clean tanks between the megasonic cleaning sub-step and also so that staging of a number of optical elements can be done. Typically three tanks are used. The first tank contains a hydrocarbon based solvent such as HPLC grade methanol or ethanol (generally a $C_1$ - $C_5$ alcohols are preferred cleaning fluids) to gently remove residues and particulates without etching the surface of the optical element. Cleaning using the hydrocarbon based solvent is carried out for a time in the range of 2 minutes to 1 hour.

The second megasonic cleaning tank contains an aqueous based detergent with a high pH (at least a pH of 9.0 and preferably at least a pH higher than the IEP (iso-electric point where surface change is zero) of the metal fluoride crystal; for $CaF_2$, pH 9.26) to help remove slurry particles from the $CaF_2$ surface more efficiently and to gently etch the surface of the substrate. For example without limitation, such detergents include Branson MC-1 (pH ~9.5) and MC-2 (pH ~ 12-12.5) [Branson Ultrasonic Corp., Danbury CT], Semiclean KG (Yokohama Oil and Fats Industry Co. Ltd.), and Valtron SP2200 (Valtech Corporation, Pottstown, Pennsylvania). Cleaning using the aqueous based detergent solvent is carried out for a time in the range of 2 minutes to 1 hour.

The third megasonic tank contains deionized ("DI") water in an overflow configuration to rinse the substrate and wash away and particulate matter or other substances that might remain on the element's surfaces. Megasonic DI rinsing also enhances the etching rate of $CaF_2$ in DI water, which in turn increases the undercutting effect to remove particles and the polishing redeposition layer. It is very important to incorporate an etching step in the cleaning process because after polishing, fractures and scratches that occurred during the grinding and polishing process can become partially or totally covered by the polishing redeposition layer which is a thin layer of material that flows while the material is being worked (cut, ground, polished). Residual, precipitated and densified polishing compound may become incorporated into the surface layer or deposited into microfractures and other surface defects. Under high energy laser irradiation, disrupted crystal lattice defects and contamination within this layer will make the optical element extremely vulnerable during laser ablation. For example, under sufficient fluence conditions in the DUV, $CaF_2$ will degrade and fluorine will desorb from the material reacting with contaminates it encounters along its route. Megasonic rinsing is carried out for a time in the range of 2 minutes to 1 hour.

When the megasonic cleaning step is completed, the cleaned element is dried, for example, using nitrogen or other inert gas or gas blend that will not react with the element, before it is subjected to the next step in the cleaning process.

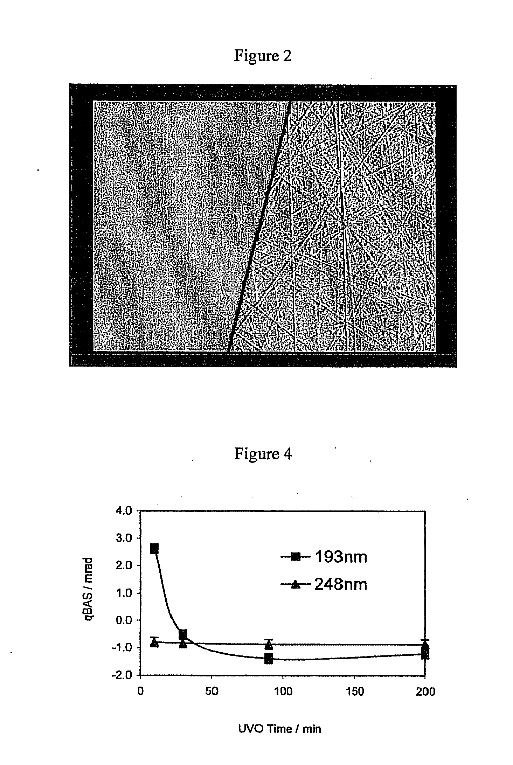

Figure 2 is a step height image of an etched $CaF_2$ element's surface after etching using DI water. To obtain the image a polished $CaF_2$ element was *partially* immersed in deionized water for 12 hours. The DI water etched surface (shown on the right side of the image) has had the polishing redeposition layer (see left side of the image) removed thus revealing scratches from the coarser polishing and grinding steps. The step height shown in Figure 2 is the result of removal of 40 nm of the top $CaF_2$ polished layer.

UVO Cleaning

Following megasonic cleaning the optical element surface would then be subjected to a UVO cleaning process. In this step the element is enclosed in a stainless steel enclosure box and exposed to UV radiation from a mercury lamp (184.9 nm and 253.7 nm) in a dry, oxygen containing environment at atmospheric pressure. The enclosure has an exhaust port to remove the main gas phase by-products, $H_2O$ and $CO_2$, from the UVO cleaning process. Air is the preferred oxygen-containing atmosphere and it can be dried using method known in the art, for example, by use of molecular sieves. The dried air is flowed into and exhausted out of the enclosure at a rate in the range of 10-30 SCCM (standard cubic centimeters per minute).

UVO cleaning is an effective solution for decontamination of hydrocarbon related substances. The UVO cleaning removes hydrocarbons by a photosensitized oxidation processes in which the contaminant molecules are excited and dissociated by the absorption of the bright line at 253.7 nm from a low-pressure mercury lamp. Simultaneously, atomic oxygen O and ozone $O_3$ are produced when oxygen is irradiated by the Hg lamp with strong emissions at 184.9nm and 253.7nm in the following manner:

$$2O_2 \xrightarrow{\ 184.9nm\ } O + O_3 \tag{1}$$

$$O_3 \xrightarrow{\ 253.7nm\ } O + O_2 \tag{2}$$

The excited contaminant molecules and the free radicals produced by the dissociation, react with the atomic oxygen generated according to Equations (1) and (2) to form simple, volatile molecules such as $CO_2$ and $H_2O$. Since $CaF_2$ is transparent to the UV source, prolonged UVO cleaning enables one to further remove some embedded contaminations. It is known that the amount of positive quasi-Brewster shift ("qBAS") is an indication of surface and subsurface contamination. Figure 4 shows the measured qBAS as a function of UVO cleaning time on $CaF_2$ at 193 nm and 248 nm. At 193 nm increased UVO cleaning time changes the qBAS from positive to negative, indicating the effectiveness of decontamination. However, at 248 nm there is no noticeable shift because contaminations are transparent at this wavelength.

Low-Energy Plasma Cleaning

The third and final step of the cleaning process consists of subjecting the optical element to a low-energy plasma containing a mixture of an inert gas, such as argon, with oxygen in a vacuum environment. For maximum benefit this final cleaning step would occur just prior to thin film deposition and can be done within the same chamber as the deposition process. One must choose these process parameters very carefully, or damage may result to the halide based substrate. It has been reported that $CaF_2$ surfaces are susceptible to fluorine loss when exposed to energetic radiation, including ion beam, electron beam and X-ray. The damaging interaction of rare gas ions with $CaF_2$ surfaces has also been observed and investigated. The main damage mechanism results in fluorine depletion from the $CaF_2$ matrix leading to high optical absorption due to color center formation. Since fluorine depletion is proportional to plasma energy, low plasma energy reduces the risk of fluorine loss. By adding $O_2$ gas into an argon plasma the cleaning process of the mixed plasma is more effective than using an argon plasma alone for removing hydrocarbon contamination.

The oxygen and argon components of the plasma cleaning gas are supplied to the chamber at the rate of approximately 15 SCCM (standard cubic centimeters per minute) $O_2$ and approximately 20 SCCM Ar. These relative flow rates can very with $O_2$ being in the range of 10-20 SCCM and Ar being in the range of 15-30 SCCM. The addition of $O_2$ to the plasma benefits the cleaning step in two ways:

(1) by enhancing the cleaning efficiency, and
(2) by greatly reducing color center formation on the $CaF_2$ surface.

By adding oxygen, any fluorine depletion related defects, including F-center and Ca colloid on the $CaF_2$ surface would be replaced by oxygen which fills in an F-center defect and reacts with Ca colloids to produce CaO. As a result color center formation is greatly reduced and unlike F-center and Ca colloids, CaO is almost transparent at 193 nm.

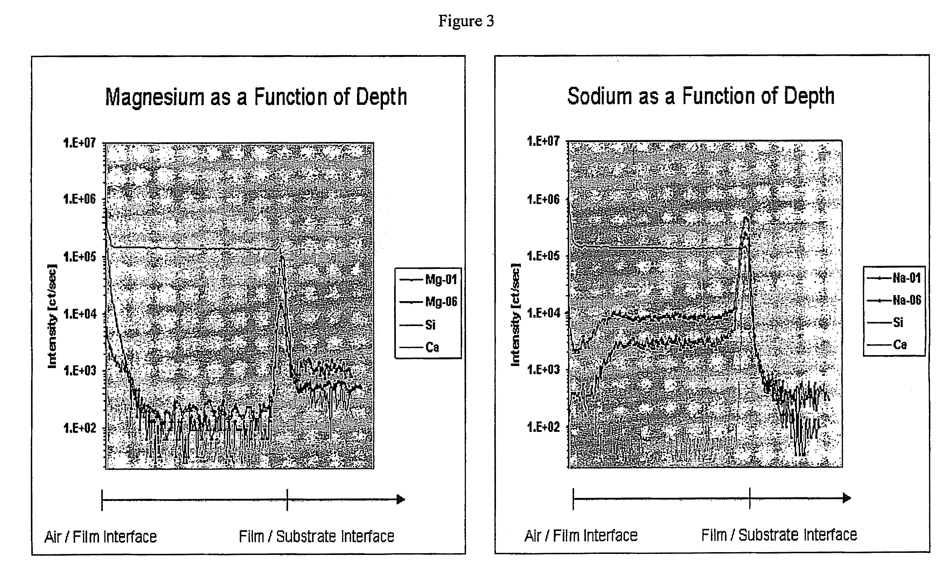

Figure 3 is a comparison of two $CaF_2$ surfaces, one $CaF_2$ surface being cleaned by wiping versus a second $CaF_2$ surface cleaned by megasonic immersion. Sample 1 was acetone wiped while Sample 6 was immersed in a deionized water megasonic operating at approximately 900 kHz, 180 watts power for 5 minutes. (Samples 1 and 6 are represented in the legends by the -01 and -06, respectively.) Both samples were then subjected to a gas phase cleaning process using a UVO and an argon/ oxygen plasma clean and then coated with a silica based film. Dynamic SIMS depth profile shows reduced sodium at the coating/substrate surface. Si and Ca are shown in the plot to define the coating/ substrate interface. In Figure 3, for the substrate, depth into the substrate goes left-to-right from the Film/Substrate interface. Testing with a pulsed laser system indicates that the lifetime of the $CaF_2$ surfaces cleaned according to invention have a longer lifetime or are slower to exhibit color center. The test results indicates that the lifetime can be extended by a factor of more than two, preferably by a factor of more than four, and more preferably by a factor of more than five.

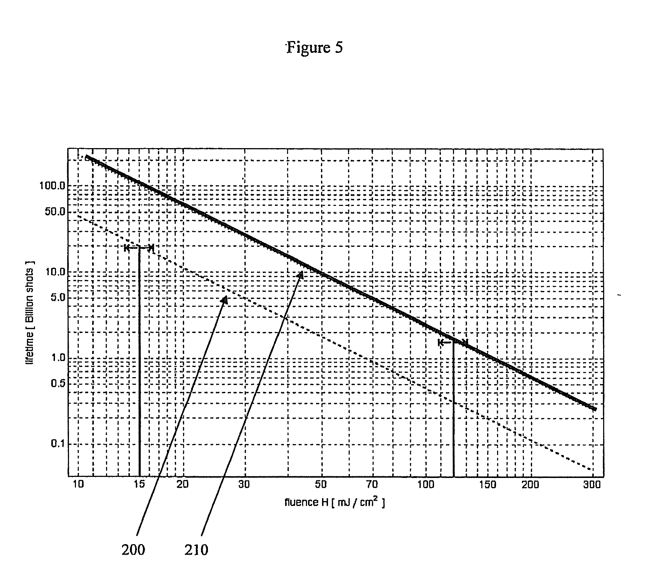

In order to compare cleaning according to the invention, laser windows were megasonically cleaned as described herein and subjected to accelerated lifetime testing. These parts were compared to laser windows that were ultrasonically cleaned according to the traditional/prior art. Figure 5 is a double logarithmic lifetime plot of megasonically cleaned windows (represented by numeral 210 and the solid black line) and traditionally cleaned windows (represented by numeral 200 and the dashed black line), respectively. The axes of the plot are billions of shots (pulses) versus fluence H in mJ/cm. In Figure 5 the samples represented by numeral 210 were tested under accelerated conditions using an average fluence H of 120 mJ/cm$^2$. These samples had an average lifetime of 1.6 billion pulses under the 120 mJ/cm$^2$ test conditions (represented by the black T line on curve 210). The solid black line indicated by arrow 210 is the projected lifetime under lower fluence conditions using an exponential scaling law. The samples megasonically cleaned according to the invention are projected to have a lifetime of 100 billion pulses at a fluence of 15 mJ/cm$^2$. For comparison, Figure 5 also shows the lifetime of a traditionally cleaned window 200 under normal (e.g., commercial) use conditions of a fluence of 15 mJ/cm$^2$ (also represented by a black T line on curve 200) and its scaling under accelerated conditions using the same scaling law. The traditionally cleaned windows have a lifetime of approximately 20 billion pulses at 15 mJ/cm$^2$. The normal used data was scaled using an exponential scaling law to illustrate lifetime under accelerated conditions. Under accelerated conditions of fluence of 120 mJ/cm$^2$, the traditionally cleaned windows have a projected lifetime of 400-500 million pulses fluence of 120 mJ/cm$^2$ (versus 1.6 billion pulses for the megasonically cleaned windows). The comparison of the windows cleaned by the two methods thus indicates that at a fluence of 15 mJ/cm$^2$ the windows megasonically cleaned according to the invention represent a 5x improvement in lifetime over the traditionally cleaned windows. That is, the windows cleaned according to the invention have a lifetime at 15 mJ/cm$^2$ of approximately 100 billion pulses versus 20 billion pulses for the traditionally cleaned windows.

The invention is also directed to a DUV optic or optical made of a single crystal alkaline earth fluoride, such element having a lifetime of at least 1.2 billion pulses of high fluence radiation (>10 mJ/cm$^2$), below 200 nm laser radiation before suffering such damage from said radiation that it has to be replaced. The alkaline earth metal can be magnesium, calcium, barium or strontium, or a mixture of two or more of the foregoing. Additionally, in one embodument the element can be coated with a selected coating material to help protect it from laser damage as described herein. The coating is applied to at least one element face through which laser or DUV radiation passes. In preferred embodiments the coating is applied to all element faces through which the laser or DUV radiation passes. The DUV optic can be a window, stepper lens, prism or other optic used in lasers, laser lithography or or other systems utilizing DUV radiation. In another embodiment the coating is applied to all faces through which the laser radiation passes. Such coatings can be selected from the group consisting of silica, fluorine doped silica, silicon nitride, fluorine doped aluminum oxide and, when said alkaline earth metal is Ca, Ba or Sr, said coating material can be $MgF_2$. In another embodiment the DUV optic $CaF_2$, coated or uncoated.

The present invention has been described in general and in detail by way of examples. Persons skilled in the art understand that the invention is not limited necessarily to the specific embodiments disclosed. Modifications and variations may be made without departing from the scope of the invention as defined by the following claims or their equivalents, including equivalent components presently known, or to be developed, which may be used within the scope of the present invention. Hence, unless changes otherwise depart from the scope of the invention, the changes should be construed as being included herein.

Embodiments of the invention include the following:

[1]. A method for cleaning the surface of $MF_2$ single crystal optical elements, said method comprising, in order, the steps of:

(a) megasonically cleaning the surface of $MF_2$ single crystal optical elements surface by immersing the element in at least one selected liquid in a megasonic cleaning bath to remove particulates, polishing slurry residue and the damaged top layer of the optical element;
(b) UV/ozone cleaning the surface of the optical element to remove hydrocarbons; and
(c) cleaning the surface of the optical element using low-energy plasma containing argon and oxygen or xenon and oxygen, or fluorine in a vacuum environment;

wherein M is selected from the group consisting of Mg, Ca, Ba and Sr.

[2]. The method according to [1] above, wherein step 1(a) consists of the sub-steps of:

(i) megasonically cleaning the optical element in a selected hydrocarbon based solvent,
(ii) megasonically cleaning the optical element in water containing a detergent at a pH of 9.0 or higher; and
(iii) megasonically rinsing and etching the optical element using deionized water in an overflow configuration

wherein the order of (i) and (ii) can be switched.

[3]. The method according to [1] above, wherein the optical element is megasonically cleaned for a time in the range of 2 minutes to 1 hour.

[4]. The method according to [2] above, wherein the megasonic cleaning time for:

the first sub-step is in the range of 2 minutes to 1 hour;
the second sub-step is in the range of 2 minutes to 1 hour; and
the third sub-step is in the range of 2 minutes to 1 hour.

[5]. The method according to [1] above, wherein said megasonic cleaning is carried out at frequencies in the approximate range of 0.7 to 2 MHz.

[6]. A method for making coated $MF_2$ optical elements for use as DUV optics using megasonic cleaning prior to coating, said method comprising.

providing a single crystal $MF_2$ optical crystal;
cutting, grinding and polishing the crystal to form an optical element,
megasonically cleaning the surface of the optical element surface by immersing the element in at least one selected liquid to remove particulates, polishing slurry residue and the damaged top layer of the optical element;
UV/ozone cleaning the surface of the optical element to remove hydrocarbons;
cleaning the surface of the optical element using low-energy plasma containing argon and oxygen in a vacuum environment; and
coating the surface of the cut, ground, polished and cleaned optical element with a selected protective coating to thereby provide a coated $MF_2$ optical DUV element for use in laser lithography;
wherein M is selected from the group consisting of Mg, Ca, Ba and Sr.

[7]. The method according to [6] above, wherein step of megasonically cleaning the surface of the optical element consists of the sub-steps of:

first, megasonically cleaning the optical element in a selected hydrocarbon based solvent,
second, megasonically cleaning the optical element in water containing a detergent at a pH of 9.0 or higher; and

third, megasonically rinsing and etching the optical element using deionized water in an overflow configuration.

[8]. The method according to [6] above, wherein the optical element is megasonically cleaned for a time in the range of 2 minutes to 1 hour at frequencies in the approximate range of 0.7 to 2 MHz.

[9]. The method according to [7] above, wherein the megasonic cleaning time for:

the first sub-step is in the range of 2 minutes to 1 hour;
the second sub-step is in the range of 2 minutes to 1 hour; and
the third sub-step is in the range of 2 minutes to 1 hour.

[10]. The method according to [6] above, wherein the selected protective coating is selected from the group consisting of silica, silicon oxyfluoride, fluorine-doped silica and fluorine containing aluminum oxide.

[11]. A DUV optic, said optic comprising a shaped single crystal alkaline earth metal fluoride optical element having a lifetime of at least 1.2 billion pulses when exposed to 120 mJ/cm$^2$ radiation, wherein said alkaline earth metal is Mg, Ca, Ba and Sr, or mixtures thereof.

[12]. The DUV element according to [11] above, wherein said element has a coating applied to at least one surface of said element through which laser light passes, said coating material being selected from the group consisting of silica, fluorine doped silica, silicon nitride, fluorine doped aluminum oxide and, when said alkaline earth metal is Ca, Ba or Sr, said coating material can be $MgF_2$.

[13]. The DUV element according to [11] above, wherein said element is a $CaF_2$ element having a coating on at least one surface through which laser light passes, said coating being selected from the group consisting of silica, fluorine doped silica, silicon nitride, fluorine doped aluminum oxide, and $MgF_2$.

[14]. The DUV element according to [11] above, wherein said DUV is a laser window or prism.

**Claims**

1. A DUV optic, said optic comprising a shaped single crystal alkaline earth metal fluoride optical element having a lifetime of at least 1.2 billion pulses when exposed to 120 mJ/cm$^2$ radiation, wherein said alkaline earth metal is Mg, Ca, Ba and Sr, or mixtures thereof.

2. The DUV element according to claim 1, wherein said element has a coating applied to at least one surface of said element through which laser light passes, said coating material being selected from the group consisting of silica, fluorine doped silica, silicon nitride, fluorine doped aluminum oxide and, when said alkaline earth metal is Ca, Ba or Sr, said coating material can be $MgF_2$.

3. The DUV element according to claim 1, wherein said element is a $CaF_2$ element having a coating on at least one surface through which laser light passes, said coating being selected from the group consisting of silica, fluorine doped silica, silicon nitride, fluorine doped aluminum oxide, and $MgF_2$.

4. The DUV element according to claim 1, wherein said DUV is a laser window or prism.

Figure 1

```
┌──────────────────┐
│       10         │
│    Polished      │
│    Substrate     │
└──────────────────┘
         │
         ▼
┌──────────────────┐  ┐
│      100         │  │
│ Megasonic Cleaning│  │
│     Alcohol      │  │
└──────────────────┘  │
         │            │
         ▼            │
┌──────────────────┐  │
│      110         │  ├  Step 1
│ Megasonic Cleaning│  │
│    Detergent     │  │
└──────────────────┘  │
         │            │
         ▼            │
┌──────────────────┐  │
│      120         │  │
│ Megasonic Cleaning│  │
│     DI water     │  │
└──────────────────┘  ┘
         │
         ▼
┌──────────────────┐  ┐
│      200         │  ├  Step 2
│   UVO Cleaning   │  ┘
└──────────────────┘
         │
         ▼
┌──────────────────┐  ┐
│      300         │  │
│ Ar/O2 Plasma     │  ├  Step 3
│    Cleaning      │  │
└──────────────────┘  ┘
         │
         ▼
┌──────────────────┐
│       20         │
│  Coat Substrate  │
└──────────────────┘
```

Figure 2

Figure 4

Figure 3

Magnesium as a Function of Depth

Sodium as a Function of Depth

Figure 5

Europäisches
Patentamt

European
Patent Office

Office européen
des brevets

# EUROPEAN SEARCH REPORT

Application Number

EP 11 18 1764

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/113777 A1 (VON DER GOENNA GORDON [DE] ET AL) 24 May 2007 (2007-05-24) | 1,4 | INV. B08B3/12 |
| Y | * abstract *<br>* paragraph [0001] - paragraph [0002] *<br>* paragraph [0013] - paragraph [0037] *<br>* claims * | 2,3 | B08B7/00<br>C30B33/00<br>G02B1/02<br>G02B1/10 |
| Y | US 2006/046099 A1 (MAIER ROBERT L [US] ET AL) 2 March 2006 (2006-03-02) | 2,3 | |
| A | * abstract *<br>* paragraph [0024] - paragraph [0027] * | 1,4 | |
| A | US 6 740 159 B2 (KANDLER JOERG [DE] ET AL) 25 May 2004 (2004-05-25)<br>* abstract *<br>* column 1, line 8 - line 10 *<br>* column 2, line 19 - column 5, line 64 * | 1-4 | |
| A | US 2002/019136 A1 (SUZUKI HIROYUKI [JP]) 14 February 2002 (2002-02-14)<br>* paragraph [0002] *<br>* abstract *<br>* paragraph [0008] - paragraph [0020] * | 1-4 | |
| | | | TECHNICAL FIELDS SEARCHED (IPC) |
| A | US 2004/202225 A1 (MAIER ROBERT L [US] ET AL) 14 October 2004 (2004-10-14)<br>* abstract *<br>* paragraph [0002] *<br>* paragraph [0004] - paragraph [0008] * | 1-4 | B08B<br>C30B<br>G02B |
| A | DE 10 2005 024682 A1 (SCHOTT AG [DE]) 14 December 2006 (2006-12-14)<br>* abstract *<br>* paragraph [0017] - paragraph [0036] * | 1-4 | |

The present search report has been drawn up for all claims

| Place of search | Date of completion of the search | Examiner |
|---|---|---|
| The Hague | 25 October 2011 | Seibert, Joachim |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 11 18 1764

This annex lists the patent family members relating to the patent documents cited in the above-mentioned European search report.
The members are as contained in the European Patent Office EDP file on
The European Patent Office is in no way liable for these particulars which are merely given for the purpose of information.

25-10-2011

| Patent document cited in search report | | Publication date | Patent family member(s) | | Publication date |
|---|---|---|---|---|---|
| US 2007113777 | A1 | 24-05-2007 | DE 102005044697 A1<br>JP 2007091583 A | | 29-03-2007<br>12-04-2007 |
| US 2006046099 | A1 | 02-03-2006 | DE 102005040324 A1<br>JP 2006072364 A<br>JP 2011081405 A | | 12-10-2006<br>16-03-2006<br>21-04-2011 |
| US 6740159 | B2 | 25-05-2004 | DE 10142649 A1<br>EP 1288348 A2<br>JP 2003137689 A<br>US 2003101923 A1 | | 24-04-2003<br>05-03-2003<br>14-05-2003<br>05-06-2003 |
| US 2002019136 | A1 | 14-02-2002 | JP 2002082211 A | | 22-03-2002 |
| US 2004202225 | A1 | 14-10-2004 | NONE | | |
| DE 102005024682 A1 | | 14-12-2006 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 96271807 P
- US 6466365 B

**Non-patent literature cited in the description**

- **T.M. STEPHEN et al.** Degradation of Vacuum Exposed SiO2 Laser Windows. *SPIE,* 1992, vol. 1848, 106-110
- **WANG et al.** Color center formation on CaF2 (111) surface investigated by using low-energy-plasma-ion surfacing. *Optical Society of America 2004,* 2004
- **WANG et al.** Surface assessment of CaF2 deep-ultraviolet and vacuum-ultraviolet optical components by the quasi-Brewster angle technique. *Applied Optics,* August 2006, vol. 45 (22), 5621-5628
- **G. GALE et al.** How to Accomplish Effective Megasonic Particle Removal. *Semiconductor International,* August 1996, 133-138
- **GALE et al.** Roles of Cavitation and Acoustic Streaming in Megasonic Cleaning. *Particulate Science and Technology,* 1999, vol. 17, 229-238